# EUROPÄISCHE PATENTSCHRIFT

(11) **EP 3 224 950 B1**
(45) Veröffentlichungstag und Bekanntmachung des Hinweises auf die Patenterteilung: **23.02.2022**
(21) Anmeldenummer: 15777629.5
(22) Anmeldetag: 22.09.2015
(51) Int. Cl.: H03K 17/16, H03K 17/12, H02M 1/088

(54) **VERFAHREN UND VORRICHTUNG ZUM ANSTEUERN PARALLEL GESCHALTETER LEISTUNGSHALBLEITERSCHALTER**
METHOD AND DEVICE FOR CONTROLLING POWER SEMICONDUCTOR SWITCHES CONNECTED IN PARALLEL
PROCÉDÉ ET DISPOSITIF DE COMMANDE D'INTERRUPTEURS À SEMI-CONDUCTEURS DE PUISSANCE MONTÉS EN PARALLÈLE

(30) Priorität: 26.11.2014 DE 102014224172
(43) Veröffentlichungstag der Anmeldung: 04.10.2017
(73) Patentinhaber: Robert Bosch GmbH, 70442 Stuttgart (DE)
(72) Erfinder: BUTZMANN, Stefan, 58579 Schalksmühle (DE); TAUFER, Peter, 71272 Renningen (DE); ECKERT, Bernd, 71665 Vaihingen An Der Enz (DE)
(86) Internationale Anmeldenummer: PCT/EP2015/071700
(87) Internationale Veröffentlichungsnummer: WO 2016/082968

(56) Entgegenhaltungen:
- EP-A2- 0 409 384
- EP-A2- 0 664 613
- DE-A1-102004 006 753
- DE-A1-102010 042 335
- US-B1- 7 906 949

## Beschreibung

Die Erfindung betrifft ein Verfahren und ein Steuergerät zum Ansteuern parallel geschalteter Leistungshalbleiterschalter. Ferner betrifft die Erfindung ein elektrisches System mit dem Steuergerät, ein Computerprogramm zur Durchführung dieses Verfahrens, sowie ein elektronisches Speichermedium.

### Stand der Technik

Zum Betreiben elektrischer Antriebe werden üblicherweise Wechselrichter eingesetzt, die die elektrische Energie aus einer Gleichspannungsquelle, z. B. einer Batterie, in eine Wechselspannung umwandeln, um eine elektrische Maschine, z.B. eine Asynchronmaschine, mit Wechselspannung bzw. Wechselstrom zu versorgen. Der Wechselrichter weist hierzu sogenannte Halbbrücken auf. Diese Halbbrücken weisen Leistungshalbleiterschalter auf, mittels denen der Gleichstrom und die Gleichspannung getaktet geschaltet werden, so dass an den Ausgangsklemmen des Wechselrichters eine Wechselspannung und ein Wechselstrom entstehen. Für diese Leistungshalbleiterschalter sind Stromobergrenzen vorgegeben, bei deren Überschreitung die Leistungshalbleiterschalter irreversibel geschädigt werden. Wenn nun höhere Ströme für den Betrieb des elektrischen Antriebs benötigt werden, werden daher diese Leistungshalbleiterschalter in den Wechselrichtern parallel geschaltet. Aufgrund von Bauteiltoleranzen werden jedoch die Leistungshalbleiterschalter auch beim parallelen Betrieb unterschiedlich stark belastet, da die Leistungshalbleiterschalter nicht gleichzeitig einschalten und daher einer der Leistungshalbleiterschalter gegebenenfalls früher einschaltet als ein anderer. Der am schnellsten und sensitivsten schaltende Leistungshalbleiterschalter trägt somit einen größeren Teil der Einschalt-, Ausschalt- und Stromleitungsverluste. Der Stromfluss zwischen den Schaltern teilt sich folglich ungleich auf die Leistungshalbleiterschalter auf. Einzelne Leistungshalbleiterschalter werden stärker thermisch belastet als andere, altern schneller und fallen somit schneller aus. Der maximale Laststrom wird daher gegebenenfalls durch die thermische Kapazität einzelner Leistungshalbleiterschalter bestimmt und nicht durch deren gesamte Stromtragfähigkeit.

Neben den unterschiedlichen Schaltzeitpunkten der einzelnen parallel geschalteten Leistungshalbleiterschalter sind bei der Ansteuerung auch die Laufzeitunterschiede der Ansteuersignale zu berücksichtigen. Ein Verfahren zur Minimierung der Laufzeitunterschiede der Ansteuersignale bei der Ansteuerung parallel geschalteter Leistungshalbleiterschalter ist aus der WO 2011/120728 A2 bekannt.

Die DE 10 2010 042 335 A1 offenbart ein Verfahren und ein Steuergerät zur Ansteuerung von zumindest teilweise parallelgeschalteten Leistungsschaltern, bei welchem die Schalter nach vorgegebenen Mustern gesteuert werden.

Die US 7 906 949 B1 offenbart einen adaptiven Regelkreis für ein Tastverhältnis.

Unter anderem wird angeführt, dass mehrere parallele Schaltelemente versetzt angesteuert werden können.

Die EP 0 664 613 A2 zeigt parallele Leistungsmodule bei denen in Abhängigkeit der Belastung die Reihenfolge der Einschaltzeiten bestimmt wird.

Es besteht daher das Bedürfnis zum Betrieb parallel geschalteter Leistungshalbleiterschalter weitere Lösungen zu entwickeln, die eine gleichmäßige Belastung parallel geschalteter Leistungshalbleiterschalter ermöglichen. So wird verhindert, dass einzelne Leistungshalbleiterschalter überlastet werden und vorzeitig ausfallen. Somit erhöht sich auch die Robustheit des gesamten Systems, in dem die parallel geschalteten Leistungshalbleiterschalter betrieben werden.

### Offenbarung der Erfindung

Es wird ein Verfahren zum Ansteuern von mindestens zwei parallel geschalteten Leistungshalbleiterschaltern zum Schalten eines Gesamtstromes gemäß Anspruch 1 bereitgestellt.

Das Verfahren dient somit der Ansteuerung parallel geschalteter Leistungshalbleiterschalter zum, insbesondere getakteten, Schalten eines Gesamtstroms. Als Leistungshalbleiterschalter sind bipolare Transistoren mit einem isolierten Gate (IGBT), Feldeffekttransistoren wie MOSFET oder weitere übliche Leistungshalbleiterschalter einsetzbar. Üblicherweise weisen die Leistungshalbleiterschalter einen Gate-Anschluss auf. In Abhängigkeit des elektrischen Potentials an dem Gate-Anschluss schaltet ein Leistungshalbleiter, er stellt eine galvanische Verbindung zwischen dem Eingangsanschluss und dem Ausgangsanschluss her, dann ist der Leistungshalbleiterschalter geschlossen und befindet sich im Zustand Schließen. Oder der Leistungshalbleiterschalter trennt den Eingangsanschluss und den Ausgangsanschluss galvanisch voneinander, dann ist der Leistungshalbleiterschalter geöffnet und befindet sich im Zustand Öffnen. Weiter ist eine Ermittlungseinheit vorgesehen, die eingangsseitig ein gemeinsames Ansteuersignal zur Ansteuerung mindestens zweier parallel geschalteten Leistungshalbleiterschalter empfängt. Das gemeinsame Ansteuersignal weist die Zustände Öffnen oder Schließen auf. Mittels der Leistungshalbleiterschalter soll entsprechend eine galvanische Verbindung zwischen dem Eingangsanschluss und dem Ausgangsanschluss getrennt oder hergestellt werden. Die Ermittlungseinheit gibt hierzu ausgangsseitig mindestens zwei Einzelansteuersignale aus, die eine Ansteuerung der mindestens zwei Leistungshalbleiterschalter zu vorgebbaren, insbesondere unterschiedlichen, Zeitpunkten bewirkt. Hierzu weisen die Einzelansteuersignale ebenfalls die Zustände Öffnen oder Schließen auf. Diese Zustände werden von den mittels der Einzelansteuersignale angesteuerten Leistungshalbleiterschaltern umgesetzt. Die mindestens zwei Einzelansteuersignale werden von der Ermittlungseinheit in Abhängigkeit des gemeinsamen Ansteuersignals derart ermittelt, dass sie sich zumindest zeitweise unterscheiden. Somit erfolgt eine zumindest teilweise individuelle Ansteuerung und ein zumindest teilweises individuelles Schalten der einzelnen parallel geschalteten Leistungshalbleiter. Die parallel geschalteten Leistungshalbleiter schalten zumindest teilweise nicht entsprechend dem gemeinsamen Ansteuersignal zu einem gemeinsamen Zeitpunkt, sondern zu unterschiedlichen nacheinander liegenden Zeitpunkten. Insbesondere erfolgt ein individuelles Schalten in Zeitabschnitten, während denen das gemeinsame Ansteuersignal den Zustand Schließen aufweist. Dies ist möglich, da bereits ein geschlossener Leistungshalbleiterschalter genügt, um eine galvanische Verbindung entsprechend des Zustands Schließen des gemeinsamen Ansteuersignals zwischen Eingangsanschluss und Ausgangsanschluss zu schaffen. Um eine galvanische Trennung zwischen dem Eingangsanschluss und dem Ausgangsanschluss entsprechend des Zustands Öffnen des gemeinsamen Ansteuersignals zu schaffen, ist insbesondere ein Öffnen aller parallel geschalteten Leistungshalbleiterschalter notwendig.

Vorteilhaft wird somit ein Verfahren bereitgestellt, welches es ermöglicht, parallel geschaltete Leistungshalbleiterschalter bewusst zu unterschiedlichen Zeitpunkten zuzuschalten. Somit wird ermöglicht, Einschalt-, Ausschalt- und Stromleitungsverluste nicht willkürlich auf einen oder wenige der parallel geschalteten Leistungshalbleiterschalter zu verteilen, sondern durch voneinander unabhängige Ansteuerung, beispielsweise durch überlappende Ansteuerung, der unterschiedlichen Leistungshalbleiterschalter gezielt und gegebenenfalls gleichmäßig auf die parallel geschalteten Leistungshalbleiterschalter zu verteilen. Insbesondere können durch Auswahl und Abwechslung der zuerst schließenden oder öffnenden Leistungshalbleiter die Einschalt-und Ausschaltverluste gezielt auf die einzelnen Leistungshalbleiter verteilt werden. Durch Variation der zeitlichen Dauer der Zustände, insbesondere des Zustands Schließen, der Einzelansteuersignale, können die Stromleitungsverluste variiert werden. Somit wird ein Verfahren geschaffen, welches ein gleichmäßigeres Verteilen der Leistung auf parallel geschaltete Leistungshalbleiterschalter bei deren Betrieb ermöglicht, auch wenn die Leistungshalbleiterschalter aufgrund ihrer Bauteiltoleranzen oder ihrer unterschiedlichen Dimensionierung unterschiedlich schnell und sensitiv auf ein Ansteuersignal reagieren. Somit wird ein Betrieb einer Parallelschaltung von Leistungshalbleiterschaltern beispielsweise aus unterschiedlichen Chargen oder Wafern oder unterschiedlicher Baugrößen oder Leistungen ohne singuläre Überlastung eines Leistungshalbleiterschalters bei optimaler Ausnutzung der Leistungsfähigkeit aller Leistungshalbleiterschalter ermöglicht
In einer Ausgestaltung der Erfindung weisen die mindestens zwei Einzelansteuerungssignale den Zustand Öffnen oder Schließen unterschiedlich lang auf.

Dies bedeutet, dass die mit den Einzelansteuerungssignalen angesteuerten Leistungshalbleiterschalter unterschiedlich lange den Zustand Öffnen oder Schließen aufweisen. An dem Leistungshalbleiterschalter, der den Zustand Schließen länger aufweist, treten länger die Stromleitungsverluste auf. Dieser Leistungshalbleiterschalter wird stärker belastet. Vorteilhaft wird ein Verfahren bereitgestellt, bei dem ein spezieller Leistungshalbleiter stärker belastet und ein anderer weniger stark belastet werden kann.

In einer anderen Ausgestaltung der Erfindung weisen die mindestens zwei Einzelansteuersignale zumindest zeitweise den gleichen Zustand Öffnen oder Schließen auf.

Bei dieser Ansteuerung der Leistungshalbleiter ergibt sich ein überlappender Betrieb. Das Ein- und Ausschalten der Leistungshalbleiter der parallel geschalteten Leistungshalbleiter erfolgt zu unterschiedlichen Zeitpunkten. Die Ein- und Ausschaltverluste werden entsprechend von unterschiedlichen Leistungshalbleiterschaltern getragen. Bei dem überlappenden Betrieb gibt es Zeitabschnitte, bei denen die mindestens zwei Leistungshalbleiter gleichzeitig den Zustand Schließen aufweisen. Die Stromleitungsverluste werden innerhalb dieses Zeitabschnittes auf beide Leistungshalbleiter verteilt. Vorteilhaft wird ein Verfahren bereitgestellt, bei dem gezielt der eine oder der andere der Leistungshalbleiter belastet werden kann.

Erfindungsgemäß erfolgt die Ermittlung der Einzelansteuersignale derart in Abhängigkeit des Ansteuersignals, dass mit dem Wechsel des Ansteuersignals von dem Zustand Öffnen in den Zustand Schließen mindestens ein erstes der Einzelansteuersignale den Zustand Öffnen beibehält und erst nach Ablauf einer ersten vorgebbaren Zeit den Zustand Schließen aufweist und dass mit dem Wechsel des Ansteuersignals von dem Zustand Öffnen in den Zustand Schließen mindestens ein zweites der Einzelansteuersignale den Zustand Schließen aufweist.

Das bedeutet, dass in Abhängigkeit eines Wechsels von dem Zustand Öffnen in den Zustand Schließen des Ansteuersignals nicht alle Leistungshalbleiterschalter parallel geschaltet oder angesteuert werden, sondern beispielsweise mindestens ein erstes Einzelansteuersignal den Zustand Öffnen weiterhin aufweist und mindestens ein zweites der Einzelansteuersignale den Zustand Schließen aufweist. Der von dem mindestens zweiten Einzelansteuersignal angesteuerte Leistungshalbleiter ermöglicht somit gemäß dem gemeinsamen Ansteuersignal den Stromfluss vom Eingangs- zum Ausgangsanschluss wohingegen der mit dem mindestens ersten Einzelansteuerungssignal angesteuerte Leitungshalbleiter noch im geöffneten Zustand verbleibt. Nach Ablauf einer ersten vorgebbaren Zeit weist auch das mindestens erste der Einzelansteuersignale den Zustand Schließen auf. Der mit dem mindestens ersten Einzelansteuersignal angesteuerte Leistungshalbleiter wird somit gezielt zeitverzögert zum gemeinsamen Ansteuersignal geschlossen. Die erste vorgegebene Zeit ist insbesondere kurz im Vergleich zu der Zeitdauer des Zustands Schließen des gemeinsamen Ansteuersignals. Die erste vorgegebene Zeit kann in Abhängigkeit der spezifischen Parameter der verwendeten Leistungshalbleiterschalter, beispielsweise derer unterschiedlichen Belastung, Schnelligkeit und Sensitivität, konstant aber auch variabel oder adaptiv in Abhängigkeit der ermittelten spezifischen Parameter vorgegeben werden. Vorteilhaft treten die Einschalt- und Stromleitungsverluste gezielt an den zunächst angesteuerten Leistungshalbleiterschaltern auf. An den anschließend zugeschalteten Leistungshalbleiterschaltern fallen deutlich geringere Einschalt- und Stromleitungsverluste an, da die Stromführung vom Eingangsanschluss zum Ausgangsanschluss bereits von den zu Beginn angesteuerten Leistungshalbleiterschaltern übernommen wird.

Gemäß der Erfindung erfolgt die Ermittlung der Einzelansteuersignale derart in Abhängigkeit des Ansteuersignals, dass mit dem Wechsel des Ansteuersignals von dem Zustand Schließen in den Zustand Öffnen das mindestens zweite Einzelansteuersignal den Zustand Schließen beibehält und erst nach Ablauf einer zweiten vorgebbaren Zeit den Zustand Öffnen aufweist und dass mit dem Wechsel des Ansteuersignals von dem Zustand Schließen in den Zustand Öffnen das mindestens erste der Einzelansteuersignale den Zustand Öffnen aufweist

Das bedeutet, dass in Abhängigkeit eines Wechsels von dem Zustand Schließen in den Zustand Öffnen des Ansteuersignals nicht alle Leistungshalbleiterschalter parallel geschaltet oder angesteuert werden, sondern beispielsweise das mindestens zweite Einzelansteuersignal den Zustand Schließen weiterhin aufweist und das mindestens erste der Einzelansteuersignale den Zustand Öffnen aufweist. Der von dem mindestens ersten Einzelansteuersignal angesteuerte Leistungshalbleiter öffnet somit gemäß dem gemeinsamen Ansteuersignal wohingegen der mit dem mindestens zweiten Einzelansteuerungssignal angesteuerte Leitungshalbleiter noch im geschlossenen Zustand verbleibt. Nach Ablauf einer zweiten vorgebbaren Zeit weist auch das mindestens zweite Einzelansteuersignale den Zustand Öffnen auf. Der mit dem mindestens zweiten Einzelansteuersignal angesteuerte Leistungshalbleiter wird somit gezielt zeitverzögert zum gemeinsamen Ansteuersignal geöffnet. Die dritte vorgegebene Zeit ist insbesondere kurz im Vergleich zu der Zeitdauer des Zustands Schließen des gemeinsamen Ansteuersignals. Die dritte vorgegebene Zeit kann in Abhängigkeit der spezifischen Parameter der verwendeten Leistungshalbleiterschalter, beispielsweise derer unterschiedlichen Belastung, Schnelligkeit und Sensitivität, konstant aber auch variabel oder adaptiv in Abhängigkeit der ermittelten spezifischen Parameter vorgegeben werden.

Vorteilhaft treten die Ausschalt- und Stromleitungsverluste gezielt an den später öffnenden Leistungshalbeleiterschaltern auf. An den davor öffnenden Leistungshalbleiterschaltern fallen deutlich geringere Ausschalt- und Stromleitungsverluste an, da die Stromführung vom Eingangsanschluss zum Ausgangsanschluss weiter von den später öffnenden Leistungshalbleiterschaltern übernommen wird. In einer anderen Ausgestaltung der Erfindung sind die erste und zweite vorgegebene Zeit gleich lang.

Wird die erste und zweite vorgegebene Zeit gleich lang vorgegeben, so sind die jeweiligen Einschalt-, und Stromleitungsverluste beziehungsweise die Ausschalt- und Stromleitungsverluste, die an den angesteuerten Leistungshalbleiterschaltern während dieser Zeiten auftreten, vergleichbar groß.

Vorteilhaft wird somit ein Verfahren geschaffen, welches es ermöglicht, gezielt die Verluste mittels der Einzelansteuersignale gleichmäßig zu verteilen.

Ferner ist es möglich, die Größe der individuellen auftretenden Verluste über die Vorgabe der Zeitdauer der vorgegeben Zeiten zu beeinflussen. Eine gezielte Belastung beziehungsweise Entlastung auswählbarer Leistungshalbleiterschalter wird somit ermöglicht.

In einer anderen Ausgestaltung der Erfindung erfolgt die Ermittlung der Einzelansteuersignale derart in Abhängigkeit des Ansteuersignals, dass bei aufeinanderfolgenden Zuständen Schließen des Ansteuersignals abwechselnd alternierend unterschiedliche Einzelansteuersignale die Zustände Öffnen aufweisen. Die Auswahl der alternierenden Einzelansteuersignale erfolgt dabei insbesondere zufällig oder nach einer festen Reihenfolge.

Das bedeutet, dass die Einzelansteuersignale derart ermittelt werden, dass stets mindestens eines der Einzelansteuersignale den Zustand Öffnen beibehält, welches nicht bereits bei dem unmittelbar vorher anliegenden Zustand Schließen des gemeinsamen Ansteuersignals, den Zustand Öffnen aufwies. Durch Vorgabe einer Reihenfolge bei der Auswahl der alternierenden Einzelansteuersignale erfolgt eine besonders gleichmäßige Belastung der Leistungshalbleiterschalter. Vorteilhaft wird somit sichergestellt, dass alle Leistungshalbleiterschalter der parallel geschalteten Leistungshalbleiterschalter gleichmäßiger belastet werden.

Gemäß der Erfindung wird die Belastung der Leistungshalbleiterschalter bestimmt und die Ermittlung eines Einzelansteuersignals zur Ansteuerung des Leistungshalbleiterschalters erfolgt in Abhängigkeit der jeweiligen Belastung des anzusteuernden Leistungshalbleiterschalters.

Das bedeutet, dass die Belastung eines jeweiligen Leistungshalbleiterschalters oder einer Untermenge der parallel geschalteten Leistungshalbleiterschalter erfasst wird und bei der Ermittlung eines Einzelansteuersignals berücksichtigt wird. Die Belastung eines mit dem Einzelansteuersignal verbundenen Leistungshalbleiterschalters, oder der Untermenge der parallel geschalteten Leistungshalbleiterschalter, wird ermittelt, indem ein Absolutwert oder auch beispielsweise ein Verlauf, beispielsweise der Temperatur eines Leistungshalbleiterschalters, ermittel wird. Ebenso lässt sich eine Belastung auch mittels einer Erfassung der Verlustleistung ermitteln, die beim Schalten und bei dem Betrieb der Leistungshalbleiterschalter auftritt. Auch aus der mittels des Leistungshalbleiterschalters übertragenen Energiemenge als Produkt des Stroms und der Spannung über der Zeit lässt sich eine Belastung des Leistungshalbleiterschalters ermitteln. Auch andere Größen können zur Ermittlung der Belastung kumuliert werden und als korrelierende Größe mit der Belastung oder Alterung des Leistungshalbleiterschalters berücksichtigt werden. Die Ermittlung eines Einzelansteuersignals kann ferner auch in Abhängigkeit einer kumulierten Belastung über der gesamten Betriebszeit eines oder einer Untermenge der parallel geschalteten Leistungshalbleiterschalter oder einer Alterung der parallel geschalteten Leistungshalbleiterschalter erfolgen, beispielsweise indem der integrierte Temperaturverlauf über der gesamten Betriebszeit eines oder einer Untermenge der parallel geschalteten Leistungshalbleiterschalter berücksichtigt wird.

Vorteilhaft wird somit ein Verfahren geschaffen, welches eine möglichst gleichmäßige Alterung der Leistungshalbleiterschalter ermöglicht, indem stets die am wenigsten belasteten Leistungshalbleiterschalter ausgewählt und mittels des entsprechend ermittelten Einzelansteuersignals für die Stromführung des Gesamtstroms vom Eingangsanschluss zum Ausgangsanschluss angesteuert und verwendet werden.

In einer weiteren Ausgestaltung der Erfindung weist ein Einzelansteuersignal den Zustand Schließen auf, wenn es einen Leistungshalbleiterschalter ansteuert, dessen Belastung geringer als ein vorgebbarer Belastungsschwellwert ist.

Dies bedeutet, dass Belastungsschwellwerte für die einzelnen Leistungshalbleiterschalter, oder einer Untermenge der parallel geschalteten Leistungshalbleiterschalter vorgegeben werden. Bei der Ermittlung eines Einzelansteuersignals wird zunächst überprüft, ob ein vorgegebener Belastungsschwellwert eines Leistungshalbleiterschalters überschritten ist. Wenn die Belastung eines Leistungshalbleiterschalters größer ist als der Belastungsschwellwert, wird das entsprechende Einzelansteuersignale derart ermittelt, dass es den Zustand Öffnen aufweist. Wenn ein Einzelansteuersignal den Zustand Schließen aufweist, steuert es einen Leistungshalbleiterschalter an, dessen Belastung geringer ist als der Belastungsschwellwert. Die Belastungsschwellwerte lassen sich aus experimentellen Temperaturmessungen an den Leistungshalbleiterschaltern oder auch anhand geeigneter Temperatur-/ Verlustleistungsmodellen bestimmen. Durch geeignete Variation der Dauer der Zustände Öffnen und Schließen der einzelnen Leistungshalbleiterschalter und durch gleichmäßigen Einsatz der Leistungshalbleiterschalter können diese gemäß ihrer Verlustleistungsgrenze betrieben werden. Selbst wenn nur noch ein Leistungshalbleiterschalter verfügbar ist, kann in einem Notlauf-Betrieb eine Stromführung mit reduzierter Leistungsfähigkeit dargestellt werden.

Vorteilhaft werden somit zu stark belastete Leistungshalbleiterschalter nicht mehr für die Stromführung des Gesamtstroms vom Eingangsanschluss zum Ausgangsanschluss vorgesehen. Eine Zerstörung eines Leistungshalbleiterschalters, welche mit einem Kurzschluss und damit mit einem Defekt des gesamten elektrischen Systems einhergehen kann, wird vermieden.

In einer anderen Ausgestaltung der Erfindung wird als Belastung eines Leistungshalbleiterschalters eine Temperatur, eine Verlustleistung, eine übertragene Energiemenge oder die Schalthäufigkeit des mit dem Einzelansteuersignal anzusteuernden Leistungshalbleiterschalters berücksichtigt.

Dies bedeutet, dass eine Belastung berücksichtigt wird, die während des Betriebs der parallel geschalteten Leistungshalbleiterschalter ermittelt wird. Beispielsweise sind dies die Temperatur eines Leistungshalbleiterschalters, die erfasste Verlustleistung, die beim Schalten und bei dem Betrieb der Leistungshalbleiterschalter auftritt, die übertragene Energiemenge als Produkt des Stroms und der Spannung über der Zeit oder die Schalthäufigkeit.

Vorteilhaft werden somit Beispiele für Belastungen eines Leistungshalbleiterschalters für das Verfahren zur Verfügung gestellt, die eine Ermittlung oder Auswahl der Einzelansteuersignale der Leistungshalbleiterschalter ermöglichen, mit denen ein zuverlässiger und betriebssicherer Betrieb der Leistungshalbleiterschalter ermöglicht wird.

In einer anderen Ausgestaltung der Erfindung wird die Funktionsfähigkeit der Leistungshalbleiterschalter bestimmt und wenn ein Einzelansteuersignal den Zustand Schließen aufweist, steuert es einen funktionsfähigen Leistungshalbleiterschalter an.

Das bedeutet, dass als defekt erkannte Leistungshalbleiterschalter der parallel geschalteten Leistungshalbleiterschalter nicht für die Stromführung des Gesamtstroms vom Eingangsanschluss zum Ausgangsanschluss verwendet werden. Es werden nur Einzelansteuersignale mit dem Zustand Schließen ausgegeben, die funktionsfähige Leistungshalbleiterschalter ansteuern.

Vorteilhaft wird somit ein betriebssicherer Betrieb des elektrischen Systems gewährleistet. Insbesondere wird ein Gesamtausfall vermieden, der durch sich gegebenenfalls bildende Kurzschlüsse hervorgerufen werden kann.

In einer anderen Ausgestaltung der Erfindung werden als parallel geschaltete Leistungshalbleiterschalter mindestens teilweise parallel geschaltete Leistungshalbleitermodule verwendet, wobei ein Leistungshalbleitermodul parallel geschaltete Leistungshalbleiterschalter umfasst.

Das bedeutet, dass statt einzelnen einzeln ansteuerbaren parallel geschalteten Leistungshalbleiterschaltern mindestens teilweise parallel geschaltete Leistungshalbleitermodule verwendet werden. Ein Leistungshalbleitermodul entspricht dabei einer Parallelschaltung mehrerer Leistungshalbleiterschalter, deren Eingangs-, Ausgangs und Ansteueranschlüsse jeweils zusammengeführt sind. Solche Leistungshalbleitermodule sind in verschiedenen Größen und Leistungsklassen bekannt und werden für die Stromführung und Unterbrechung höherer elektrischer Leistungen mittels eines Ansteuersignals verwendet.

Vorteilhaft wird somit ein Betrieb parallel geschalteter Leistungshalbleitermodule ermöglicht, bei dem die einzelnen Leistungshalbleitermodule ebenfalls gleichmäßiger belastet werden, als wenn alle Leistungshalbleitermodule mittels einem Ansteuersignal angesteuert werden und aufgrund ihrer Bauteiltoleranzen oder ihrer unterschiedlichen Dimensionierung unterschiedlich schnell und sensitiv auf ein Ansteuersignal reagieren. Es ergeben sich somit für den Betrieb der parallel geschalteten Leistungshalbleitermodule vergleichbare Vorteile wie für den Betrieb parallel geschalteter Leistungshalbleiterschalter.

Ferner wird ein Steuergerät zum Ansteuern von mindestens zwei parallel geschalteten Leistungshalbleiterschaltern zum Schalten eines Gesamtstroms nach Anspruch 10 bereitgestellt.

Das Steuergerät dient somit der Ansteuerung parallel geschalteter Leistungshalbleiterschalter zum, insbesondere getakteten, Schalten eines Gesamtstroms. Weiter ist eine Ermittlungseinheit vorgesehen, die eingangsseitig ein gemeinsames Ansteuersignal zur Ansteuerung mindestens zweier parallel geschalteten Leistungshalbleiterschalter empfängt. Das gemeinsame Ansteuersignal weist die Zustände Öffnen oder Schließen auf, welche von den Leistungshalbleiterschaltern zumindest teilweise umgesetzt werden sollen. Ausgangsseitig gibt die Ermittlungseinheit hierzu mindestens zwei Einzelansteuersignale aus zur Ansteuerung der mindestens zwei Leistungshalbleiterschalter zu vorgebbaren, insbesondere unterschiedlichen, Zeitpunkten. Hierzu weisen die Einzelansteuersignale ebenfalls die Zustände Öffnen oder Schließen auf. Diese Zustände werden von den mittels der Einzelansteuersignale angesteuerten Leistungshalbleiterschaltern umgesetzt. Die mindestens zwei Einzelansteuersignale werden von der Ermittlungseinheit in Abhängigkeit des gemeinsamen Ansteuersignals derart ermittelt, dass sie sich zumindest zeitweise unterscheiden. Somit erfolgt eine zumindest teilweise individuelle Ansteuerung und ein zumindest teilweises individuelles Schalten der einzelnen parallel geschalteten Leistungshalbleiter. Die parallel geschalteten Leistungshalbleiter schalten zumindest teilweise nicht entsprechend dem gemeinsamen Ansteuersignal zu einem gemeinsamen Zeitpunkt, sondern zu unterschiedlichen nacheinander liegenden Zeitpunkten. Insbesondere erfolgt ein individuelles Schalten in Zeitabschnitten, während denen das gemeinsame Ansteuersignal den Zustand Schließen aufweist. Dies ist möglich, da bereits ein geschlossener Leistungshalbleiterschalter genügt, um eine galvanische Verbindung entsprechend des Zustands Schließen des gemeinsamen Ansteuersignals zwischen Eingangsanschluss und Ausgangsanschluss zu schaffen. Um eine galvanische Trennung zwischen dem Eingangsanschluss und dem Ausgangsanschluss entsprechend des Zustands Öffnen des gemeinsamen Ansteuersignals zu schaffen, ist insbesondere ein Öffnen aller parallel geschalteten Leistungshalbleiterschalter notwendig.

Vorteilhaft wird somit ein Steuergerät bereitgestellt, welches es ermöglicht, parallel geschaltete Leistungshalbleiterschalter bewusst zu unterschiedlichen Zeitpunkten zuzuschalten. Somit wird ermöglicht, Einschalt-, Ausschalt- und Stromleitungsverluste nicht willkürlich auf einen oder wenige der parallel geschalteten Leistungshalbleiterschalter zu verteilen, sondern durch voneinander unabhängige Ansteuerung, beispielsweise durch alternierende Ansteuerung, der unterschiedlichen Leistungshalbleiterschalter gezielt und gegebenenfalls gleichmäßig auf die parallel geschalteten Leistungshalbleiterschalter zu verteilen. Somit wird eine Vorrichtung geschaffen, welche ein gleichmäßigeres Verteilen der Leistung auf parallel geschaltete Leistungshalbleiterschalter bei deren Betrieb ermöglicht, auch wenn die Leistungshalbleiterschalter aufgrund ihrer Bauteiltoleranzen oder ihrer unterschiedlichen Dimensionierung unterschiedlich schnell und sensitiv auf ein Ansteuersignal reagieren. Somit wird der Betrieb einer Parallelschaltung von Leistungshalbleiterschaltern beispielsweise aus unterschiedlichen Chargen oder Wafern oder unterschiedlicher Baugrößen oder Leistungen ohne singuläre Überlastung eines Leistungshalbleiterschalters bei optimaler Ausnutzung der Leistungsfähigkeit aller Leistungshalbleiterschalter ermöglicht.

Ferner wird ein elektrisches System bereitgestellt, welches ein oben beschriebenes Steuergerät und parallel geschaltete Leistungshalbleiterschalter zum Schalten eines Gesamtstroms innerhalb eines Fahrzeuges umfasst.

Somit wird ein elektrisches System bereitgestellt, welches den Anforderungen innerhalb eines Fahrzeuges genügt und eine hohe Betriebssicherheit parallel geschalteter Leistungshalbleiterschalter aufweist.

Es versteht sich, dass die Merkmale, Eigenschaften und Vorteile des erfindungsgemäßen Verfahrens entsprechend auf das erfindungsgemäße Steuergerät bzw. auf das elektrische System und umgekehrt zutreffen bzw. anwendbar sind. Weitere Merkmale und Vorteile von Ausführungsformen der Erfindung ergeben sich aus der nachfolgenden Beschreibung mit Bezug auf die beigefügten Zeichnungen.

### Kurze Beschreibung der Zeichnungen

Im folgenden soll die Erfindung anhand einiger Figuren näher erläutert werden, dazu zeigen:
Figur 1
   ein elektrisches System mit einem Steuergerät in einer schematischen Darstellung.
Figur 2
   eine Darstellung der Ansteuersignale über der Zeit.
Figur 3
   ein Ablaufdiagramm für ein Verfahren zur Ansteuerung parallel geschalteter Leistungshalbleiterschalter zum Schalten eines Gesamtstroms.

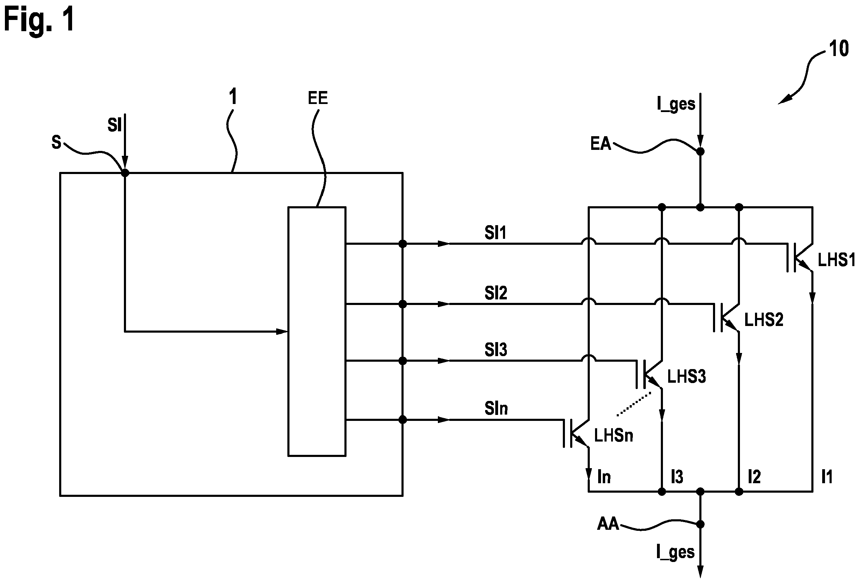

Die Figur 1 zeigt ein elektrisches System 10 in einer schematischen Darstellung. Dem elektrischen System 10 wird ein Gesamtstrom I_ges an einem Eingangsanschluss EA zugeführt. Parallel geschaltete Leistungshalbleiterschalter LHS1..LHSn sind eingangsseitig mit dem Eingangsanschluss EA verbunden und ausgangsseitig mit dem Ausgangsanschluss AA verbunden. Der Gesamtstrom I_ges teilt sich auf die Leistungshalbleiterschalter auf, die geschlossen sind, also den Zustand Schließen aufweisen. Entsprechend entspricht die Summe der Einzelströme I1..In durch die jeweiligen parallel geschalteten Leistungshalbleiter LHS1..LHSn stets dem Gesamtstrom I_ges. Über den Ausgangsanschluss AA wird der Gesamtstrom I_ges abgeleitet. Die parallel geschalteten Leistungshalbleiterschalter LHS1..LHSn dienen sowohl der Stromführung als auch der Unterbrechung des Stromflusses vom Eingangsanschluss EA zum Ausgangsanschluss AA. Die parallel geschalteten Leistungshalbleiterschalter LHS1..LHSn weisen jeweils einen Gate-Anschluss auf. Die Gate-Anschlüsse untereinander sind insbesondere voneinander getrennt. Beispielhaft ist in der Zeichnung dargestellt, dass jeder einzelne Leistungshalbleiterschalter einen einzelnen Gate-Anschluss aufweist. Weiter umfasst das elektrische System 10 ein Steuergerät 1, welches einen gemeinsamen Ansteueranschluss S zur Entgegennahme eines gemeinsamen Ansteuersignals SI aufweist. Das Steuergerät umfasst eine Ermittlungseinheit EE, welcher das Ansteuersignal SI zugeführt wird. Das Ansteuersignal weist die Zustände Öffnen oder Schließen auf. Die Ermittlungseinheit EE ermittelt in Abhängigkeit des Ansteuersignals SI Einzelansteuersignale SI1..SIn. Die Einzelansteuersignale (SI1..SIn) weisen jeweils die Zustände Öffnen oder Schließen auf. Die Einzelansteuersignale SI1..SIn werden von der Ermittlungseinheit EE ausgegeben und an die Gate-Anschlüsse zur Ansteuerung der Leistungshalbleiterschalter übertragen. Vorteilhaft wird somit ermöglicht, das gemeinsame Ansteuersignal SI auf mehrere voneinander unabhängige einzelne Einzelansteuersignale SI1..SIn zu übertragen. So können für die Stromführung des Gesamtstroms I_ges vom Eingangsanschluss EA zum Ausgangsanschluss AA gezielt einzelne oder eine Untermenge der parallel geschalteten Leistungshalbleiterschalter LHS1..LHSn mittels der Einzelansteuersignale SI1..SIn angesteuert und für die Stromführung verwendet werden. Entsprechendes gilt insbesondere auch für die Verwendung von parallel geschalteten Leistungshalbleitermodule anstelle der parallel geschalteten Leistungshalbleiterschalter LHS1..LHSn.

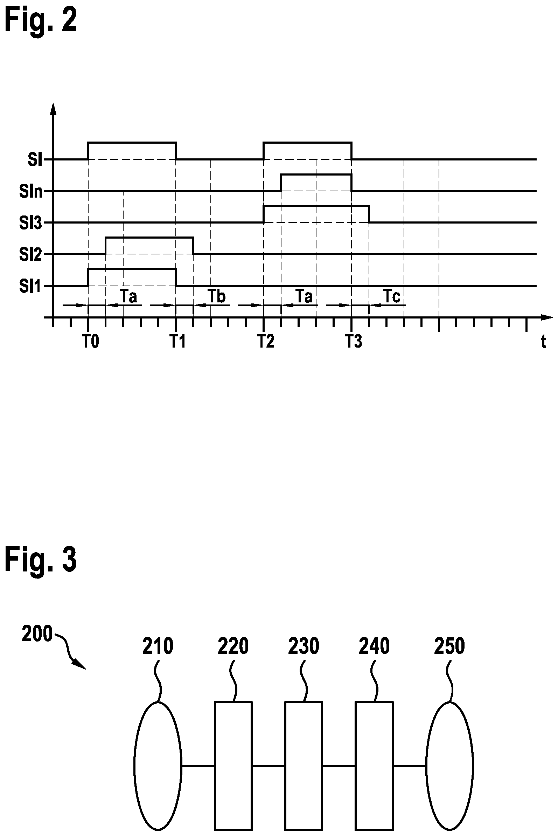

Die Figur 2 zeigt verschiedene Ansteuersignale, die über der Zeitachse t aufgetragen sind. In der obersten Zeile ist das, beispielsweise getaktete, gemeinsame Ansteuersignal SI zu erkennen, welches zwischen den Zeitpunkten T0 und T1 und T2 und T3 jeweils den Zustand Schließen und sonst den Zustand Öffnen aufweist. In Abhängigkeit des Ansteuersignals SI ermittelt die Ermittlungseinheit EE Einzelansteuersignale SI1..SIn. Mittels des elektrischen Systems 10 soll zu den Zeitpunkten zu dem das Ansteuersignal SI den Zustand Schließen aufweist der Gesamtstrom I_ges vom Eingangsanschluss zum Ausgangsanschluss geführt werden. In Figur 2 sind weiter beispielhaft die Einzelansteuersignale SI1..SIn für einen überlappenden Betrieb der Leistungshalbleiterschalter LHS1..LHSn dargestellt. So weist das Einzelansteuersignal SI1 während des ersten Zustands Schließen des Ansteuersignals SI ebenfalls den Zustand Schließen auf. Somit wird der Leistungshalbleiterschalter LHS1 zur Übertragung des Gesamtstroms angesteuert. Zum Zeitpunkt T0 behält das Einzelansteuersignal SI2 zunächst den Zustand Öffnen bei. Nach Ablauf der ersten vorgegebenen Zeit Ta weist auch das Einzelansteuersignal SI2 den Zustand Schließen auf. Das Einzelansteuersignal SI2 weist den Zustand Schließen weiter auf bis nach den Zeitpunkt T1, bei dem der Wechsel des Zustands des Ansteuersignals SI von Schließen auf Öffnen erfolgt, und den Ablauf der anschließenden zweiten vorgegebenen Zeit Tb. In diesem Beispiel übernimmt der Leistungshalbleiterschalter LHS1 die Einschalt- und Stromleitungsverluste während der ersten vorgegebenen Zeit Ta und der Leistungshalbleiterschalter LHS2 die Ausschalt- und Stromleitungsverluste während einer weiteren vorgegebenen Zeit Tb.

Bei dem darauf folgenden Wechsel des Zustands des Ansteuersignals SI von Öffnen auf Schließen zum Zeitpunkt T2 wird ein weiterer Leistungshalbleiterschalter LHS3 mittels des Einzelansteuersignal SI3 mit dem Zustand Schließen angesteuert. Der Leistungshalbleiterschalter LHS3 wird zur Übertragung des Gesamtstroms angesteuert. Das Einzelansteuersignal SIn behält zunächst den Zustand Öffnen bei. Nach Ablauf einer Zeit nach dem Zeitpunkt T2, in diesem Beispiel nochmals mit der Dauer der ersten vorgegeben Zeit Ta, weist das Einzelansteuersignal SIn den Zustand Schließen auf. Nach dem Zeitpunkt T3, bei dem der Wechsel des Zustands des Ansteuersignals SI von Schließen auf Öffnen erfolgt, weist das Einzelansteuersignal SIn den Zustand Öffnen auf. Das Einzelansteuersignal SI3 weist den Zustand Schließen weiter auf bis nach den Zeitpunkt T3 und den Ablauf der anschließenden zweiten vorgegebenen Zeit Tc. In diesem Beispiel übernimmt der Leistungshalbleiterschalter LHS3 sowohl die Einschalt-und Stromleitungsverluste während der vorgegebenen Zeit Ta und die Ausschalt- und Stromleitungsverluste während der zweiten vorgegebenen Zeit Tc. Da in diesem Beispiel sowohl die Einschalt- und Stromleitungsverluste während der ersten vorgegebenen Zeit Ta als auch die Ausschalt- und Stromleitungsverluste während der zweiten vorgegebenen Zeit Tc auf den oder die mit dem Einzelansteuersignal SI3 angesteuerten Leistungshalbleiterschalter LHS3 verteilt wird, werden diese Leistungshalbleiterschalter in diesem Beispiel stärker belastet als die mit dem Einzelansteuersignal SIn angesteuerten Leistungshalbleiterschalter LHSn. Je nach Wahl beziehungsweise Ermittlung der Einzelansteuersignale lässt sich die Belastung auf die Leistungshalbleiterschalter LHS1..LHSn gezielt verteilen.

Figur 3 zeigt ein Verfahren 200 zum Ansteuern parallel geschalteter Leistungshalbleiterschalter zum Schalten eines Gesamtstroms I_ges. Im Schritt 210 startet das Verfahren. In Schritt 220 wird das gemeinsame Ansteuersignal SI empfangen. In Schritt 230 werden die Einzelansteuersignale SI1..SIn in Abhängigkeit des Ansteuersignals SI ermittelt. In Schritt 240 werden die Einzelansteuersignale SI1..SIn zur Ansteuerung der Leistungshalbleiterschalter ausgegeben. Mit Schritt 250 endet das Verfahren.

## Patentansprüche

1. Verfahren (200) zum Ansteuern von mindestens zwei parallel geschalteten Leistungshalbleiterschaltern (LHS1..LHSn) zum Schalten eines Gesamtstroms (I_ges),
wobei die mindestens zwei parallel geschalteten Leistungshalbleiterschalter (LHS1..LHSn) jeweils einen Gate-Anschluss zur Ansteuerung des jeweiligen Leistungshalbleiterschalters (LHS1..LHSn) aufweisen,
mit den Schritten:
Bereitstellen eines Eingangsanschlusses (EA) zum Zuführen des Gesamtstroms (I_ges), eines Ausgangsanschlusses (AA) zum Ableiten des Gesamstroms (I_ges) und eines gemeinsamen Ansteueranschlusses (S) zur Entgegennahme eines gemeinsamen Ansteuersignals (SI), welches die Zustände Öffnen oder Schließen aufweist,
wobei die mindestens zwei parallel geschalteten Leistungshalbleiterschalter (LHS1..LHSn) eingangsseitig mit dem Eingangsanschluss (EA) und ausgangsseitig mit dem Ausgangsanschluss (AA) verbunden sind;
Bereitstellen mindestens einer Ermittlungseinheit (EE), die dazu eingerichtet ist, eingangsseitig das gemeinsame Ansteuersignal (SI) zu empfangen und mindestens zwei Einzelansteuersignale (SI1..SIn) in Abhängigkeit des gemeinsamen Ansteuersignals (SI) zur Ansteuerung der mindestens zwei Leistungshalbleiterschalter (LHS1..LHSn) zu ermitteln und ausgangsseitig die mindestens zwei ermittelten Einzelansteuersignale an die jeweiligen Gate-Anschlüsse der mindestens zwei Leistungshalbleiterschalter auszugeben,
wobei die mindestens zwei Einzelansteuersignale (SI1..SIn) jeweils die Zustände Öffnen oder Schließen aufweisen und sich die mindestens zwei Einzelansteuersignale (SI1..SIn) mindestens zeitweise unterscheiden;
wobei die Ermittlung der Einzelansteuersignale (SI1..SIn) derart in Abhängigkeit des Ansteuersignals (SI) erfolgt, dass mit dem Wechsel des Ansteuersignals (SI) von dem Zustand Öffnen in den Zustand Schließen mindestens ein erstes der Einzelansteuersignale (SI1..SIn) den Zustand Öffnen beibehält und erst nach Ablauf einer ersten vorgebbaren Zeit (Ta) den Zustand Schließen aufweist
und dass mit dem Wechsel des Ansteuersignals (SI) von dem Zustand Öffnen in den Zustand Schließen mindestens ein zweites der Einzelansteuersignale (SI1..SIn) den Zustand Schließen aufweist, und
wobei die Ermittlung der Einzelansteuersignale (SI1..SIn) derart in Abhängigkeit des Ansteuersignals (SI) erfolgt, dass mit dem Wechsel des Ansteuersignals (SI) von dem Zustand Schließen in den Zustand Öffnen das mindestens zweiten Einzelansteuersignal (SI1..SIn) den Zustand Schließen beibehält und erst nach Ablauf einer zweiten vorgebbaren Zeit (Tc) den Zustand Öffnen aufweist
und dass mit dem Wechsel des Ansteuersignals (SI) von dem Zustand Schließen in den Zustand Öffnen das mindestens zweite Einzelansteuersignale (SI1..SIn) den Zustand Öffnen aufweist, und
wobei die erste vorgegebene Zeit und die zweite vorgegebene Zeit adaptiv in Abhängigkeit ermittelter spezifischer Parameter der verwendeten Leistungshalbleiterschalter vorgegeben werden, wobei die spezifischen Parameter derer unterschiedlichen Belastung, Schnelligkeit und Sensitivität aufweisen,
wobei die Belastung der Leistungshalbleiterschalter (LHS1..LHSn) bestimmt wird und die Ermittlung eines Einzelansteuersignals (SI1..SIn) in Abhängigkeit der jeweiligen Belastung des anzusteuernden Leistungshalbleiterschalters (LHS1..LHSn) erfolgt.

2. Verfahren nach Anspruch 1,
wobei die mindestens zwei Einzelansteuersignale (SI1..SIn) unterschiedlich lang den Zustand Öffnen oder Schließen aufweisen.

3. Verfahren nach einem der vorhergehenden Ansprüche,
wobei die mindestens zwei Einzelansteuersignale (SI1..Sin) zumindest zeitweise den gleichen Zustand Öffnen oder Schließen aufweisen.

4. Verfahren nach Anspruch 1,
wobei die erste und die zweite vorgegebene Zeit (Ta, Tc) gleich lang sind.

5. Verfahren nach einem der vorhergehenden Ansprüche,
wobei die Ermittlung der Einzelansteuersignale (SI1..Sin) derart in Abhängigkeit des Ansteuersignals (SI) erfolgt, dass bei aufeinanderfolgenden Zuständen Schließen des Ansteuersignals (SI) abwechselnd alternierend unterschiedliche Einzelansteuersignale (SI1..Sin) die Zustände Öffnen aufweisen.

6. Verfahren nach Anspruch 1,
wobei ein Einzelansteuersignal (SI1..Sin) den Zustand Schließen aufweist, wenn es einen Leistungshalbleiterschalter (LHS1..LHSn) ansteuert, dessen Belastung geringer als ein vorgebbarer Belastungsschwellwert ist.

7. Verfahren nach Anspruch 6,
wobei zur Bestimmung einer Belastung eines Leistungshalbleiterschalters (LHS1..LHSn) dessen Temperatur, dessen Verlustleistung, dessen übertragene Energiemenge oder dessen Schalthäufigkeit berücksichtigt wird.

8. Verfahren nach einem der vorhergehenden Ansprüche,
wobei die Funktionsfähigkeit der Leistungshalbleiterschalter (LHS1..LHSn) bestimmt wird und ein Einzelansteuersignal (SI1..Sin) den Zustand Schließen aufweist, wenn es einen funktionsfähigen Leistungshalbleiterschalter ansteuert (LHS1..LHSn).

9. Verfahren nach einem der vorhergehenden Ansprüche,
wobei als parallel geschaltete Leistungshalbleiterschalter (LHS1..LHSn) mindestens teilweise parallel geschaltete Leistungshalbleitermodule verwendet werden, wobei ein Leistungshalbleitermodul parallel geschaltete Leistungshalbleiterschalter (LHS1..LHSn) umfasst.

10. Steuergerät (1) zum Ansteuern von mindestens zwei parallel geschalteten Leistungshalbleiterschaltern (LHS1..LHSn) zum Schalten eines Gesamtstroms (I_ges),
wobei die mindestens zwei parallel geschalteten Leistungshalbleiterschalter (LHS1..LHSn) jeweils einen Gate-Anschluss zur Ansteuerung des jeweiligen Leistungshalbleiterschalters (LHS1..LHSn) aufweisen und der Gesamtstrom (I_ges) über einen Eingangsanschluss (EA) zugeführt und über einen Ausgangsanschluss (AA) abgeleitet wird und die mindestens zwei parallel geschalteten Leistungshalbleiterschalter (LHS1..LHSn) eingangsseitig mit dem Eingangsanschluss (EA) und ausgangsseitig mit dem Ausgangsanschluss (AA) verbunden sind;
umfassend einen gemeinsamen Ansteueranschlusses (S) zur Entgegennahme eines gemeinsamen Ansteuersignals (SI), welches die Zustände Öffnen oder Schließen aufweist,
und mindestens eine Ermittlungseinheit (EE), die dazu eingerichtet ist, das gemeinsame Ansteuersignal (SI) zu empfangen und mindestens zwei Einzelansteuersignale (SI1..Sin) in Abhängigkeit des gemeinsamen Ansteuersignals (SI) zur Ansteuerung der mindestens zwei Leistungshalbleiterschalter (LHS1..LHSn) zu ermitteln und ausgangsseitig die mindestens zwei ermittelten Einzelansteuersignale an die jeweiligen Gate-Anschlüsse der mindestens zwei Leistungshalbleiterschalter auszugeben;
wobei die mindestens zwei Einzelansteuersignale (SI1..Sin) jeweils die Zustände Öffnen oder Schließen aufweisen und sich die mindestens zwei Einzelansteuersignale (SI1..Sin) mindestens zeitweise unterscheiden, und
wobei die mindestens eine Ermittlungseinheit (EE) dazu eingerichtet ist, die Ermittlung der Einzelansteuersignale (SI1..Sin) derart in Abhängigkeit des Ansteuersignals (SI) durchzuführen, dass mit dem Wechsel des Ansteuersignals (SI) von dem Zustand Öffnen in den Zustand Schließen mindestens ein erstes der Einzelansteuersignale (SI1..Sin) den Zustand Öffnen beibehält und erst nach Ablauf einer ersten vorgebbaren Zeit (Ta) den Zustand Schließen aufweist und dass mit dem Wechsel des Ansteuersignals (SI) von dem Zustand Öffnen in den Zustand Schließen mindestens ein zweites der Einzelansteuersignale (SI1..Sin) den Zustand Schließen aufweist, und
wobei die mindestens eine Ermittlungseinheit (EE) dazu eingerichtet ist, die Ermittlung der Einzelansteuersignale (SI1..Sin) derart in Abhängigkeit des Ansteuersignals (SI) durchzuführen, dass mit dem Wechsel des Ansteuersignals (SI) von dem Zustand Schließen in den Zustand Öffnen das mindestens zweiten Einzelansteuersignal (SI1..Sin) den Zustand Schließen beibehält und erst nach Ablauf einer zweiten vorgebbaren Zeit (Tc) den Zustand Öffnen aufweist und dass mit dem Wechsel des Ansteuersignals (SI) von dem Zustand Schließen in den Zustand Öffnen das mindestens zweite Einzelansteuersignale (SI1..Sin) den Zustand Öffnen aufweist, und
wobei die mindestens eine Ermittlungseinheit (EE) dazu eingerichtet ist, die erste vorgegebene Zeit und die zweite vorgegebene Zeit adaptiv in Abhängigkeit ermittelter spezifischer Parameter der verwendeten Leistungshalbleiterschalter vorzugeben, wobei die spezifischen Parameter derer unterschiedlichen Belastung, Schnelligkeit und Sensitivität aufweisen,
wobei die mindestens eine Ermittlungseinheit (EE) dazu eingerichtet ist, die Belastung der Leistungshalbleiterschalter (LHS1..LHSn) zu bestimmen und die Ermittlung eines Einzelansteuersignals (SI1..Sin) in Abhängigkeit der jeweiligen Belastung des anzusteuernden Leistungshalbleiterschalters (LHS1..LHSn) erfolgt.

11. Elektrisches System (10), umfassend ein Steuergerät (1) gemäß Anspruch 10 und parallel geschaltete Leistungshalbleiterschalter (LHS1..LHSn) zum Schalten eines Gesamtstroms (I_ges) innerhalb eines Fahrzeuges.

## Claims

1. Method (200) for controlling at least two power semiconductor switches (LHSl..LHSn) connected in parallel for switching a total current (I_tot), wherein the at least two power semiconductor switches (LHSl..LHSn) connected in parallel each have a gate terminal for controlling the respective power semiconductor switch (LHS1..LHSn), comprising the following steps:
providing an input terminal (EA) for feeding the total current (I_tot), an output terminal (AA) for conducting away the total current (I_tot) and a common control terminal (S) for receiving a common control signal (SI) having the states open or close, wherein the at least two power semiconductor switches (LHSl..LHSn) connected in parallel are connected to the input terminal (EA) on the input side and to the output terminal (AA) on the output side;
providing at least one ascertaining unit (EE) configured to receive the common control signal (SI) on the input side and to ascertain at least two individual control signals (SIl..SIn) depending on the common control signal (SI) for controlling the at least two power semiconductor switches (LHSl..LHSn) and, on the output side, to output the at least two individual control signals ascertained to the respective gate terminals of the at least two power semiconductor switches,
wherein the at least two individual control signals (SIl..SIn) each have the states open or close and the at least two individual control signals (SIl..SIn) differ at least at times;
wherein ascertaining the individual control signals (SIl..SIn) is carried out depending on the control signal (SI) in such a way that, with the change in the control signal (SI) from the state open to the state close, at least one first of the individual control signals (SIl..SIn) maintains the state open and has the state close only after a first predefinable time (Ta) has elapsed,
and that, with the change in the control signal (SI) from the state open to the state close, at least one second of the individual control signals (SIl..SIn) has the state close, and
wherein ascertaining the individual control signals (SIl..SIn) is carried out depending on the control signal (SI) in such a way that, with the change in the control signal (SI) from the state close to the state open, the at least second individual control signal (SIl..SIn) maintains the state close and has the state open only after a second predefinable time (Tc) has elapsed,
and that, with the change in the control signal (SI) from the state close to the state open, the at least second individual control signal (SIl..SIn) has the state open, and
wherein the first predefined time and the second predefined time are adaptively predefined depending on ascertained specific parameters of the power semiconductor switches used, wherein the specific parameters include the different loading, speed and sensitivity thereof,
wherein the loading of the power semiconductor switches (LHSl..LHSn) is determined and ascertaining an individual control signal (SIl..SIn) is carried out depending on the respective loading of the power semiconductor switch (LHSl..LHSn) to be controlled.

2. Method according to Claim 1,
wherein the at least two individual control signals (SIl..SIn) have the state open or close for different lengths of time.

3. Method according to either of the preceding claims,
wherein the at least two individual control signals (SIl..Sin) have the same state open or close at least at times.

4. Method according to Claim 1,
wherein the first and second predefined times (Ta, Tc) are of the same length.

5. Method according to any of the preceding claims,
wherein ascertaining the individual control signals (SIl..Sin) is carried out depending on the control signal (SI) in such a way that, in the case of successive states close of the control signal (SI), alternately different individual control signals (SIl..Sin) have the states open in an alternating manner.

6. Method according to Claim 1,
wherein an individual control signal (SIl..Sin) has the state close if it controls a power semiconductor switch (LHSl..LHSn) whose loading is lower than a predefinable loading threshold value.

7. Method according to Claim 6,
wherein, in order to determine a loading of a power semiconductor switch (LHS1..LHSn), the temperature thereof, the power loss thereof, the transmitted quantity of energy thereof or the switching frequency thereof is taken into account.

8. Method according to any of the preceding claims,
wherein the functionality of the power semiconductor switches (LHSl..LHSn) is determined and an individual control signal (SIl..Sin) has the state close if it controls a functional power semiconductor switch (LHS1..LHSn).

9. Method according to any of the preceding claims,
wherein at least partly parallel-connected power semiconductor modules are used as power semiconductor switches (LHSl..LHSn) connected in parallel, wherein a power semiconductor module comprises power semiconductor switches (LHSl..LHSn) connected in parallel.

10. Control device (1) for controlling at least two power semiconductor switches (LHSl..LHSn) connected in parallel for switching a total current (I_tot), wherein the at least two power semiconductor switches (LHSl..LHSn) connected in parallel each have a gate terminal for controlling the respective power semiconductor switch (LHS1..LHSn), and the total current (I_tot) is fed via an input terminal (EA) and is conducted away via an output terminal (AA), and the at least two power semiconductor switches (LHSl..LHSn) connected in parallel are connected to the input terminal (EA) on the input side and to the output terminal (AA) on the output side;
comprising a common control terminal (S) for receiving a common control signal (SI) having the states open or close,
and at least one ascertaining unit (EE) configured to receive the common control signal (SI) and to ascertain at least two individual control signals (SIl..Sin) depending on the common control signal (SI) for controlling the at least two power semiconductor switches (LHSl..LHSn) and, on the output side, to output the at least two individual control signals ascertained to the respective gate terminals of the at least two power semiconductor switches;
wherein the at least two individual control signals (SIl..Sin) each have the states open or close and the at least two individual control signals (SIl..Sin) differ at least at times, and
wherein the at least one ascertaining unit (EE) is configured to carry out the ascertaining of the individual control signals (SIl..Sin) depending on the control signal (SI) in such a way that, with the change in the control signal (SI) from the state open to the state close, at least one first of the individual control signals (SIl..Sin) maintains the state open and has the state close only after a first predefinable time (Ta) has elapsed, and that, with the change in the control signal (SI) from the state open to the state close, at least one second of the individual control signals (SIl..Sin) has the state close, and
wherein the at least one ascertaining unit (EE) is configured to carry out the ascertaining of the individual control signals (SIl..Sin) depending on the control signal (SI) in such a way that, with the change in the control signal (SI) from the state close to the state open, the at least second individual control signal (SIl..Sin) maintains the state close and has the state open only after a second predefinable time (Tc) has elapsed, and that, with the change in the control signal (SI) from the state close to the state open, the at least second individual control signal (SIl..Sin) has the state open, and
wherein the at least one ascertaining unit (EE) is configured to adaptively predefine the first predefined time and the second predefined time depending on ascertained specific parameters of the power semiconductor switches used, wherein the specific parameters include the different loading, speed and sensitivity thereof,
wherein the at least one ascertaining unit (EE) is configured to determine the loading of the power semiconductor switches (LHSl..LHSn) and ascertaining an individual control signal (SIl..Sin) is carried out depending on the respective loading of the power semiconductor switch (LHSl..LHSn) to be controlled.

11. Electrical system (10), comprising a control device (1) according to Claim 10 and power semiconductor switches (LHSl..LHSn) connected in parallel for switching a total current (I_tot) within a vehicle.

## Revendications

1. Procédé (200) permettant de piloter au moins deux commutateurs à semi-conducteurs de puissance (LHSl..LHSn) connectés en parallèle pour commuter un courant total (I_ges),
les au moins deux commutateurs à semi-conducteurs de puissance (LHSl..LHSn) connectés en parallèle présentant respectivement une borne de grille pour piloter le commutateur à semi-conducteurs de puissance (LHSl..LHSn) respectif,
comprenant les étapes consistant à :
prévoir une borne d'entrée (EA) pour alimenter le courant total (I_ges), une borne de sortie (AA) pour dissiper le courant total (I_ges) et une borne de pilotage commune (S) pour recevoir un signal de pilotage commun (SI) qui présente les états ouverture ou fermeture,
les au moins deux commutateurs à semi-conducteurs de puissance (LHSl..LHSn) connectés en parallèle étant reliés côté entrée à la borne d'entrée (EA) et côté sortie à la borne de sortie (AA) ;
prévoir au moins une unité de détection (EE) qui est aménagée pour recevoir côté entrée le signal de pilotage commun (SI) et pour détecter au moins deux signaux de pilotage individuels (SIl..SIn) en fonction du signal de pilotage commun (SI) pour piloter les au moins deux commutateurs à semi-conducteurs de puissance (LHSl..LHSn) et pour sortir côté sortie les au moins deux signaux de pilotage individuels détectés à destination des bornes de grille respectives des au moins deux commutateurs à semi-conducteurs de puissance,
les au moins deux signaux de pilotage individuels (SIl..SIn) présentant respectivement les états ouverture ou fermeture, et les au moins deux signaux de pilotage individuels (SIl..SIn) étant différents au moins par temporairement ;
la détection des signaux de pilotage individuels (SIl..SIn) étant effectuée en fonction du signal de pilotage (SI) de telle sorte qu'avec le passage du signal de pilotage (SI) de l'état d'ouverture à l'état de fermeture, au moins un premier des signaux de pilotage individuels (SIl..SIn) conserve l'état d'ouverture et ne présente l'état de fermeture qu'après expiration d'un premier délai prédéfinissable (Ta),
et en ce qu'avec le passage du signal de pilotage (SI) de l'état d'ouverture à l'état de fermeture, au moins un deuxième des signaux de pilotage individuels (SIl..SIn) présente l'état de fermeture, et
la détection des signaux de pilotage individuels (SIl..SIn) étant effectuée en fonction du signal de pilotage (SI) de telle sorte qu'avec le passage du signal de pilotage (SI) de l'état de fermeture à l'état d'ouverture, ledit au moins deuxième signal de pilotage individuel (SIl..SIn) conserve l'état de fermeture et ne présente l'état d'ouverture qu'après expiration d'un deuxième délai prédéfinissable (Tc),
et en ce qu'avec le passage du signal de pilotage (SI) de l'état de fermeture à l'état d'ouverture, ledit au moins deuxième signal de pilotage individuel (SIl..SIn) présente l'état d'ouverture, et
le premier délai prédéfini et le deuxième délai prédéfini étant prédéfinis de manière adaptative en fonction de paramètres spécifiques détectés des commutateurs à semi-conducteurs de puissance utilisés, les paramètres spécifiques présentant leur charge, leur vitesse et leur sensibilité différentes,
la charge des commutateurs à semi-conducteurs de puissance (LHSl..LHSn) étant déterminée, et la détection d'un signal de pilotage individuel (SI1 ... SIn) étant effectuée en fonction de la charge respective du commutateur à semi-conducteurs de puissance (LHSl..LHSn) à piloter.

2. Procédé selon la revendication 1,
dans lequel les au moins deux signaux de pilotage individuels (SI1..SIn) présentent une durée différente de l'état d'ouverture ou de fermeture.

3. Procédé selon l'une quelconque des revendications précédentes,
dans lequel les au moins deux signaux de pilotage individuels (SIl..Sin) présentent au moins temporairement le même état d'ouverture ou de fermeture.

4. Procédé selon la revendication 1,
dans lequel le premier et le deuxième délai prédéfinis (Ta, T_{C}) ont la même durée.

5. Procédé selon l'une quelconque des revendications précédentes,
dans lequel la détection des signaux de pilotage individuels (SIl..Sin) est effectuée en fonction du signal de pilotage (SI) de telle sorte que dans le cas d'états de fermeture consécutifs du signal de pilotage (SI), différents signaux de pilotage individuels (SIl..Sin) présentent tour à tour les états d'ouverture en alternance.

6. Procédé selon la revendication 1,
dans lequel un signal de pilotage individuel (SIl..Sin) présente l'état de fermeture lorsqu'il pilote un commutateur à semi-conducteurs de puissance (LHSl..LHSn) dont la charge est inférieure à une valeur seuil de charge prédéfinissable.

7. Procédé selon la revendication 6,
dans lequel, pour la détermination d'une charge d'un commutateur à semi-conducteurs de puissance (LHS1..LHSn), sa température, sa puissance dissipée, sa quantité d'énergie transmise ou sa fréquence de commutation est prise en considération.

8. Procédé selon l'une quelconque des revendications précédentes,
dans lequel la capacité de fonctionnement des commutateurs à semi-conducteurs de puissance (LHS1..LHSn) est déterminée, et un signal de pilotage individuel (SIl..Sin) présente l'état de fermeture s'il pilote un commutateur à semi-conducteurs de puissance (LHSl..LHSn) en état de fonctionnement.

9. Procédé selon l'une quelconque des revendications précédentes,
dans lequel, comme commutateurs à semi-conducteurs de puissance (LHSl..LHSn) connectés en parallèle, on utilise des modules à semi-conducteurs de puissance connectés au moins partiellement en parallèle, un module à semi-conducteurs de puissance comprenant des commutateurs à semi-conducteurs de puissance (LHSl..LHSn) connectés en parallèle.

10. Appareil de commande (1) permettant de piloter au moins deux commutateurs à semi-conducteurs de puissance (LHS1..LHSn) connectés en parallèle pour commuter un courant total (I_ges),
les au moins deux commutateurs à semi-conducteurs de puissance (LHSl..LHSn) connectés en parallèle présentant respectivement une borne de grille pour piloter le commutateur à semi-conducteurs de puissance (LHSl..LHSn) respectif, et le courant total (I_ges) est alimenté par une borne d'entrée (EA) et est dissipé par une borne de sortie (AA), et les au moins deux commutateurs à semi-conducteurs de puissance (LHS1..LHSn) connectés en parallèle étant reliés côté entrée à la borne d'entrée (EA) et côté sortie à la borne de sortie (AA) ;
comprenant une borne de pilotage commune (S) pour recevoir un signal de pilotage commun (SI) qui présente les états ouverture ou fermeture,
et au moins une unité de détection (EE) qui est aménagée pour recevoir le signal de pilotage commun (SI) et pour détecter au moins deux signaux de pilotage individuels (SIl..Sin) en fonction du signal de pilotage commun (SI) pour piloter les au moins deux commutateurs à semi-conducteurs de puissance (LHS1..LHSn) et pour sortir côté sortie les au moins deux signaux de pilotage individuels détectés à destination des bornes de grille respectives des au moins deux commutateurs à semi-conducteurs de puissance ;
les au moins deux signaux de pilotage individuels (SIl..Sin) présentant respectivement les états ouverture ou fermeture, et les au moins deux signaux de pilotage individuels (SIl..Sin) étant différents au moins temporairement, et
ladite au moins une unité de détection (EE) étant aménagée pour effectuer la détection des signaux de pilotage individuels (SIl..Sin) en fonction du signal de pilotage (SI) de telle sorte qu'avec le passage du signal de pilotage (SI) de l'état d'ouverture à l'état de fermeture, au moins un premier des signaux de pilotage individuels (SIl..Sin) conserve l'état d'ouverture et ne présente l'état de fermeture qu'après expiration d'un premier délai prédéfinissable (Ta), et en ce qu'avec le passage du signal de pilotage (SI) de l'état d'ouverture à l'état de fermeture, au moins un deuxième des signaux de pilotage individuels (SIl..Sin) présente l'état de fermeture, et
ladite au moins une unité de détection (EE) étant aménagée pour effectuer la détection des signaux de pilotage individuels (SIl..Sin) en fonction du signal de pilotage (SI) de telle sorte qu'avec le passage du signal de pilotage (SI) de l'état de fermeture à l'état d'ouverture, ledit au moins deuxième signal de pilotage individuel (SIl..Sin) conserve l'état de fermeture et ne présente l'état d'ouverture qu'après expiration d'un deuxième délai prédéfinissable (Tc), et en ce qu'avec le passage du signal de pilotage (SI) de l'état de fermeture à l'état d'ouverture, ledit au moins deuxième signal de pilotage individuel (SIl..Sin) présente l'état d'ouverture, et
ladite au moins une unité de détection (EE) étant aménagée pour prédéfinir le premier délai prédéfini et le deuxième délai prédéfini de manière adaptative en fonction de paramètres spécifiques détectés des commutateurs à semi-conducteurs de puissance utilisés, les paramètres spécifiques présentant leur charge, leur vitesse, et leur sensibilité différentes,
ladite au moins une unité de détection (EE) étant aménagée pour déterminer la charge des commutateurs à semi-conducteurs de puissance (LHS1..LHSn), et la détection d'un signal de pilotage individuel (SIl..Sin) étant effectuée en fonction de la charge respective du commutateur à semi-conducteurs de puissances (LHS1..LHSn) à piloter.

11. Système électrique (10), comprenant un appareil de commande (1) selon la revendication 10 et des commutateurs à semi-conducteurs de puissance (LHSl..LHSn) connectés en parallèle pour commuter un courant total (I_ges) à l'intérieur d'un véhicule.
